# EUROPÄISCHE PATENTSCHRIFT

(11) **EP 1 266 403 B1**
(45) Veröffentlichungstag und Bekanntmachung des Hinweises auf die Patenterteilung: **02.12.2009**
(21) Anmeldenummer: 01935935.5
(22) Anmeldetag: 22.03.2001
(51) Int. Cl.: H01L 21/60, H01L 23/31

(54) **VERFAHREN ZUM VERBINDEN MINDESTENS EINES CHIPS MIT EINER UMVERDRAHTUNGSANORDNUNG**
METHOD FOR CONNECTING AT LEAST ONE CHIP TO A REWIRING ARRANGEMENT
PROCEDE PERMETTANT DE CONNECTER AU MOINS UNE PUCE AVEC UN CABLAGE

(30) Priorität: 23.03.2000 DE 10014379
(43) Veröffentlichungstag der Anmeldung: 18.12.2002
(73) Patentinhaber: Qimonda AG i.IN., 81739 München (DE)
(72) Erfinder: HAUSER, Christian, 93049 Regensburg (DE); REISS, Martin, 93047 Regensburg (DE); WINDERL, Johann, 92442 Wackersdorf (DE)
(74) Vertreter: Beck, Josef
(86) Internationale Anmeldenummer: PCT/DE2001/001107
(87) Internationale Veröffentlichungsnummer: WO 2001/071773

(56) Entgegenhaltungen:
- EP-A- 0 863 548
- US-A- 4 731 645
- PATENT ABSTRACTS OF JAPAN vol. 1997, no. 09, 30. September 1997 (1997-09-30) -& JP 09 130000 A (CASIO COMPUT CO LTD), 16. Mai 1997 (1997-05-16)
- PATENT ABSTRACTS OF JAPAN vol. 1996, no. 05, 31. Mai 1996 (1996-05-31) -& JP 08 008293 A (CASIO COMPUT CO LTD), 12. Januar 1996 (1996-01-12)
- PATENT ABSTRACTS OF JAPAN vol. 2000, no. 04, 31. August 2000 (2000-08-31) -& JP 2000 012608 A (FUJITSU LTD), 14. Januar 2000 (2000-01-14)

## Beschreibung

Die Erfindung betrifft ein Verfahren zum Verbinden mindestens eines Chips mit einer Umverdrahtungsanordnung.

Bisher ist die Erstellung einer derartigen elektrisch leitenden Verbindung durch Wire Bonding oder Lead Bonding eines Chips mit seiner Umverdrahtungsebene (= Umverdrahtungsanordnung; z.B. Leiterbahnen auf einem Trägermaterial) üblich. Ein Wire-Bonding-Verfahren ist zum Beispiel in der US 5,147,815 beschrieben.

Die US 4,731,645, die EP 0 863 548 A2, die JP 09-130000A, die JP 08-008293 A sowie die JP 2000-12608A offenbaren jeweils ein Verfahren, bei dem ein Umverdrahtungssubstrat mit Durchöffnungen direkt auf einem Halbleiterchip aufgebracht wird und danach ein elektrisch leitendes Material in die Durchöffnungen eingebracht wird, um das Umverdrahtungssubstrat mit dem Halbleiterchip elektrisch zu verbinden.

Aufgabe der vorliegenden Erfindung ist eine effiziente, rationelle Erstellung einer elektrischen Verbindung eines Chips (bzw. deren Chippads, also Kontaktierungsflächen) mit seiner Umverdrahtungsebene (= Umverdrahtungsanordnung; z.B. Leiterbahnen auf einem Trägermaterial). Die Aufgabe wird durch die Gegenstände des unabhängigen Anspruchs gelöst.

Das erfindungsgeämße Verfahren ist ein sehr einfacher, kostengünstig realisierbarer Prozeß. Der maschinelle Aufwand ist sehr gering. Eventuell kann auf eine Umhüllung der Bondverbindung verzichtet werden, da die erfindungsgemäße Verbindung selbst ausreichend stabil ist. Die erfindungsgemäße Verbindung ist sehr effizient herstellbar. Erfindungsgemäß ist insbesondere die gleichzeitige und damit rationelle Verbindung mehrerer noch auf einem Wafer befindlicher Chips mit ihren Umverdrahtungsebenen möglich.

Als elektrisch verbindendes Kontaktmaterial ist insbesondere ein elektrisch leitender Kleber oder ein selbstaushärtendes oder unter Hitze aushärtendes Material geeignet.

Das Kontaktmaterial wird vorzugsweise durch einen Print-Prozeß (Aufdrucken) oder Dispensen (Verteilen einer Masse) aufgetragen.

Das Verfahren ist insbesondere für Produkte aus dem Bereich WSA (wafer scale assembly = Verbindungserstellung ohne die Chips aus dem Wafer herauszutrennen), FBGA (Fine Pitch Ball Grind Array = Gehäuse mit Lötkugeln auf der Chipunterseite zum Ermöglichen einer einfachen Montage), CSP (Chip Size Package = Gehäuse mit an die Chipgröße angepaßter Größe), Module Assembly (Modulare Montage), COB (Chip on board) einsetzbar.

Weitere Merkmale und Vorteile der Erfindung ergeben sich aus den Ansprüchen und der nachfolgenden Beschreibung eines Ausführungsbeispiels anhand der Zeichnung. Dabei zeigt:
- Figur 1: schematisch einen erfindungsgemäß mit einer Umverdrahtungsebene kontaktierbaren Chip und
- Figur 2: die Anordnung in Figur 1 mit eingebrachtem Kontaktiermaterial.

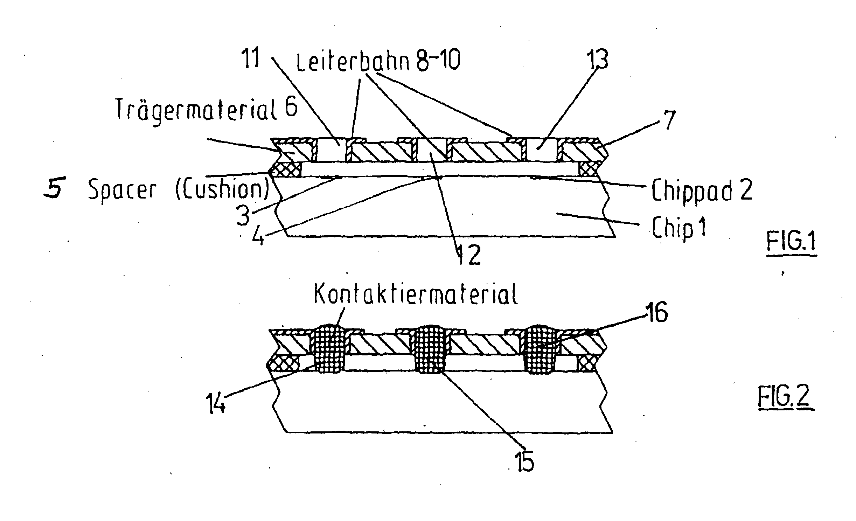

Figur 1 zeigt einen Chip 1 mit Chippads 2, 3, 4 (= Kontaktierungsbereiche des Chips), der durch Abstandshalter (Spacer Cushion 5) von einer Umverdrahtungsanordnung 6-10 (umfassend Trägermaterial 6, 7 und Leiterbahnen 8, 9, 10) distanziert wird.

Im Bereich der Leiterbahnen sind Ausnehmungen 11, 12, 13 in der Umverdrahtungsanordnung mit geeigneter Form dort vorgesehen (z.B. durch gebohrte Löcher etc), wo eine Verbindung zwischen einem Chippad und einer Leiterbahn etc. der Umverdrahtungsanordnung entstehen soll. Die dargestellten Ausnehmungen 11, 12, 13 sind Durchgangsausnehmungen, z.B. Durchgangsbohrungen, die sich durch die Umverdrahtungsanordnung erstrecken, um eine einfache Einbringung eines Kontaktierungsmaterials zum Verbinden mindestens eines Chips mit einer Umverdrahtungsanordnung zu ermöglichen.

Figur 2 zeigt die Anordnung aus Figur 1 mit in die Ausnehmungen 11, 12, 13 eingebrachtem (hier pastösem) Kontaktierungsmaterial 14, 15, 16, durch welches mindestens ein Chippad des Chips 1 mit der Umverdrahtungsanordnung elektrisch leitend verbunden wird. Dabei können auch mehrere noch auf einem Wafer befindliche Chips in einem Prozeßschritt sehr effizient mit ihrer jeweils zugehörigen Umverdrahtungsanordnung kontaktiert werden. Die Einbringung erfolgt z.B. durch einen Print Prozeß (= Aufdrucken) oder einen Dispensing-Prozeß (Aufstreichen etc.).

Das elektrisch leitende Kontaktierungsmaterial kann unterschiedlichster Konsistenz sein, z.B. ein elektrisch leitender Kleber oder ein selbstaushärtendes oder unter Hitze aushärtendes Material etc..

Wie aus Figur 2 anschaulich ersichtlich ist kann auf eine Umhüllung der Bondverbindung verzichtet werden, da die Verbindung selbst ausreichend mechanisch stabil ist.
Ferner ist ersichtlich, daß eine Repair-Möglichkeit besteht, also ein Austauschen/Ersetzen von elektrisch nicht einwandfreien Chips auf z.B. einer Leiterplatte. Hierbei wird die Verbindung zwischen der Leiterplatte und dem Chip aufgelöst und die Leiterplatte eventuell gereinigt bzw. auf einen neuen Kontaktiervorgang vorbereitet.
Anschließend kann ein neuer Chip an der Stelle des alten (defekten, abgelösten) Chips kontaktiert werden, ohne daß die Leiterplatte verworfen werden muß. Darauf wird die Leiterplatte nochmals getestet und es erfolgt erforderlichenfalls ein weiterer Repairdurchlauf.

Zusammenfassend wird eine elektrisch leitende Verbindung zwischen einem Chip und einer Umverdrahtungsanordnung durch Einbringung eines elektrisch leitenden Kontaktmaterials in Ausnehmungen der Umverdrahtungsanordnung erstellt, was rationell ausführbar ist und eine mechanisch sehr stabile elektrische Verbindung von Chippads mit ihren Umverdrahtungsebenen ermöglicht.

## Patentansprüche

1. Verfahren zum Verbinden mindestens eines Chips mit einer Umverdrahtungsanordnung, umfassend die Verfahrensschritte:
Bereitstellen eines Chips (1) mit Chippads (2-4);
Bereitstellen einer Umverdrahtungsanordnung (6-10) mit einem Trägermaterial (6, 7), Leiterbahnen (8-10) und Durchgangsausnehmungen (11-13), wobei die Durchgangsausnehmungen (11-13) durch Löcher in dem Trägermaterial (6, 7) gebildet werden und ein Teil der Leiterbahnen (8-10) auf Seitenwänden der Löcher angeordnet ist;
Anordnen des Chips (1) in einem Abstand zu der Umverdrahtungsanordnung (6-10) durch Abstandshalter (5), so dass ein Zwischenraum zwischen der Umverdrahtungsanordnung (6-10) und dem Chip (1) gebildet wird; und
Herstellen einer elektrisch leitenden Verbindung zwischen Chippads (2-4) des Chips (1) und Leiterbahnen (8-10) der Umverdrahtungsanordnung (6-10) nach Anordnen des Chips (1) in einem Abstand zu der Umverdrahtungsanordnung (6-10) durch Einbringen eines elektrisch leitenden Kontaktmaterials (14-16) in Durchgangsausnehmungen (11-13) der Umverdrahtungsanordnung (6-10), wobei das Kontaktmaterial (14-16) derart in die Durchgangsausnehmungen (11-13) eingebracht wird, dass das Kontaktmaterial (14-16) die Chippads (2-4) und den Teil der Leiterbahnen (8-10) an den Seitenwänden der Löcher kontaktiert und eine Kavität zwischen der Umverdrahtungsanordnung (6-10) und dem Chip (1) in Bereichen außerhalb des Kontaktmaterials (14-16) und der Abstandshalter (5) gebildet wird.

2. Verfahren nach Anspruch 1, wobei in einem Arbeitsschritt mehrere Chips (1) mit der Umverdrahtungsanordnung (6-10) kontaktiert werden.

3. Verfahren nach einem der vorhergehenden Ansprüche, wobei sich beim Kontaktieren die Chips (1) noch auf einem Wafer befinden.

4. Verfahren nach einem der vorhergehenden Ansprüche, wobei das Kontaktmaterial (14-16) eine Paste ist.

5. Verfahren nach einem der vorhergehenden Ansprüche, wobei das Kontaktmaterial (14-16) ein elektrisch leitender Klebstoff ist.

6. Verfahren nach einem der vorhergehenden Ansprüche, wobei das Kontaktmaterial (14-16) ein aushärtendes Material ist.

7. Verfahren nach einem der vorhergehenden Ansprüche, wobei es für ein Fine Pitch Ball Grid Array-Produkt verwendet wird.

8. Verfahren nach einem der vorhergehenden Ansprüche, wobei es für ein Chip Size Package-Produkt verwendet wird.

9. Verfahren nach einem der vorhergehenden Ansprüche, wobei es für ein WSA-Produkt verwendet wird.

10. Verfahren nach einem der vorhergehenden Ansprüche, wobei es für ein Module Assembly-Produkt verwendet wird.

11. Verfahren nach einem der vorhergehenden Ansprüche, wobei es für ein Chip on Board-Produkt verwendet wird.

12. verfahren nach einem der vorhergehenden Ansprüche, wobei das Kontaktmaterial (14-16) in die Durchgangsausnehmungen (11-13) durch einen Print-Prozess eingebracht wird.

13. Verfahren nach einem der vorhergehenden Ansprüche, wobei das Kontaktmaterial (14-16) in die Durchgangsausnehmungen (11-13) durch Dispensing eingebracht wird.

## Claims

1. Method for connecting at least one chip to a redistribution wiring arrangement, comprising the following method steps:
providing a chip (1) having chip pads (2-4);
providing a redistribution wiring arrangement (6-10) having a carrier material (6, 7), interconnects (8-10) and through-cutouts (11-13), wherein the through-cutouts (11-13) are formed by holes in the carrier material (6, 7) and a portion of the interconnects (8-10) is arranged on sidewalls of the holes;
arranging the chip (1) at a distance from the redistribution wiring arrangement (6-10) by means of spacers (5), such that an interspace is formed between the redistribution wiring arrangement (6-10) and the chip (1); and
producing an electrically conductive connection between chip pads (2-4) of the chip (1) and interconnects (8-10) of the redistribution wiring arrangement (6-10) after arranging the chip (1) at a distance from the redistribution wiring arrangement (6-10) by means of introducing an electrically conductive contact material (14-16) in through-cutouts (11-13) of the redistribution wiring arrangement (6-10), wherein the contact material (14-16) is introduced into the through-cutouts (11-13) in such a way that the contact material (14-16) makes contact with the chip pads (2-4) and the portion of the interconnects (8-10) on the sidewalls of the holes and a cavity is formed between the redistribution wiring arrangement (6-10) and the chip (1) in regions outside the contact material (14-16) and the spacers (5).

2. Method according to Claim 1, wherein a plurality of chips (1) are contact-connected to the redistribution wiring arrangement (6-10) in one work step.

3. Method according to any of the preceding claims, wherein the chips (1) are still situated on a wafer during contact-connection.

4. Method according to any of the preceding claims, wherein the contact material (14-16) is a paste.

5. Method according to any of the preceding claims, wherein the contact material (14-16) is an electrically conductive adhesive.

6. Method according to any of the preceding claims, wherein the contact material (14-16) is a curing material.

7. Method according to any of the preceding claims, wherein it is used for a fine pitch ball grid array product.

8. Method according to any of the preceding claims, wherein it is used for a chip size package product.

9. Method according to any of the preceding claims, wherein it is used for a WSA product.

10. Method according to any of the preceding claims, wherein it is used for a module assembly product.

11. Method according to any of the preceding claims, wherein it is used for a chip on board product.

12. Method according to any of the preceding claims, wherein the contact material (14-16) is introduced into the through-cutouts (11-13) by means of a printing process.

13. Method according to any of the preceding claims, wherein the contact material (14-16) is introduced into the through-cutouts (11-13) by means of dispensing.

## Revendications

1. Procédé pour relier au moins une puce à un système de recâblage, et comportant les étapes qui consistent à :
préparer une puce (1) dotée de pattes (2-4) de puce,
préparer un système (6-10) de recâblage qui présente un matériau de support (6, 7), des pistes conductrices (8-10) et des découpes de passage (11-13), les découpes de passage (11-13) étant formées par des trous ménagés dans le matériau de support (6, 7), une partie des pistes conductrices (8-10) étant disposée sur les parois latérales des trous,
disposer la puce (1) à distance du système de recâblage (6-10) à l'aide d'écarteurs (5) de manière à former un espace intermédiaire entre le système de recâblage (6-10) et la puce (1),
établir une liaison électriquement conductrice entre les pattes (2-4) de la puce (1) et les pistes conductrices (8-10) du système de recâblage (6-10) après avoir placé la puce (1) à distance du système de recâblage (6-10), en plaçant un matériau électriquement conducteur de contact (14-16) dans les découpes de passage (11-13) du système de recâblage (6-10),
le matériau de contact (14-16) étant placé dans les découpes de passage (11-13) de telle sorte que le matériau de contact (14-16) entre en contact avec les pattes de puce (2-4) et la partie des pistes conductrices (8-10) disposée sur les parois latérales des trous et qu'une cavité soit formée entre le système de recâblage (6-10) et la puce (1) dans les zones situées à l'extérieur du matériau de contact (14-16) et les écarteurs (5).

2. Procédé selon la revendication 1, dans lequel plusieurs puces (1) sont mises en contact avec le système de recâblage (6-10) en une seule étape de travail.

3. Procédé selon l'une des revendications précédentes, dans lequel lors de la mise en contact, les puces (1) sont encore situées sur une galette.

4. Procédé selon l'une des revendications précédentes, dans lequel le matériau de contact (14-16) est une pâte.

5. Procédé selon l'une des revendications précédentes, dans lequel le matériau de contact (14-16) est un adhésif électriquement conducteur.

6. Procédé selon l'une des revendications précédentes, dans lequel le matériau de contact (14-16) est un matériau durcissant.

7. Procédé selon l'une des revendications précédentes, utilisé pour un produit en grille de billes à petit pas ("Fine Pitch Ball Grid Array").

8. Procédé selon l'une des revendications précédentes, utilisé pour un produit de conditionnement de la taille d'une puce.

9. Procédé selon l'une des revendications précédentes, utilisé pour un produit WSA.

10. Procédé selon l'une des revendications précédentes, utilisé pour un produit constitué d'un ensemble de modules.

11. Procédé selon l'une des revendications précédentes, utilisé pour un produit à puce sur carte.

12. Procédé selon l'une des revendications précédentes, dans lequel le matériau de contact (14-16) est placé dans les découpes de passage (11-13) par une opération d'impression.

13. Procédé selon l'une des revendications précédentes, dans lequel le matériau de contact (14-16) est placé dans les découpes de passage (11-13) par distribution.
